# EUROPÄISCHE PATENTSCHRIFT

(11) **EP 3 235 070 B1**
(45) Veröffentlichungstag und Bekanntmachung des Hinweises auf die Patenterteilung: **28.04.2021**
(21) Anmeldenummer: 15810787.0
(22) Anmeldetag: 18.12.2015
(51) Int. Cl.: H01R 13/6582, H01R 13/6592, H01R 13/6596, H05K 9/00

(54) **SCHIRMKONTAKTELEMENT**
SHIELD CONTACT ELEMENT
ÉLÉMENT DE CONTACT DE BLINDAGE

(30) Priorität: 18.12.2014 DE 102014118952
(43) Veröffentlichungstag der Anmeldung: 25.10.2017
(73) Patentinhaber: Hirschmann Automotive GmbH, 6830 Rankweil-Brederis (AT)
(72) Erfinder: BREUSS, Lukas, 6830 Rankweil (AT); METZLER, Andreas, 6835 Muntlix (Zwischenwasser) (AT); WEISS, Marco, 6830 Rankweil (AT)
(74) Vertreter: Greif, Thomas
(86) Internationale Anmeldenummer: PCT/EP2015/080614
(87) Internationale Veröffentlichungsnummer: WO 2016/097353

(56) Entgegenhaltungen:
- WO-A1-2008/109109
- WO-A1-2011/124562
- WO-A1-2014/108197
- DE-A1-102012 219 509
- DE-A1-102012 219 509
- GB-A- 2 066 591

## Beschreibung

Die Erfindung betrifft ein Schirmkontaktelement mit axial zueinander beabstandeten an einem hohlzylindrischen Grundkörper angeordneten Federelementen, wobei mittels der Federelemente einerseits die Kontaktierung zu einer Abschirmung eines Kabels und andererseits die Kontaktierung zu einem elektrischen Gerät erfolgt, gemäß Anspruch 1.

WO2011124562 offenbart ein Schirmkontaktelement gemäß den Merkmalen des Oberbegriffes des Anspruchs 1. Ein gattungsgemäßes Schirmkontaktelement ist aus der DE 20 2013 006 413 U1 bekannt. Zur Kontaktierung einer Abschirmung eines Kabels mit einem elektrischen Gerät, insbesondere dessen Gehäuse aus einem metallischen Werkstoff, ist eine Kontakthülse bekannt, die einen hohlzylindrischen Grundkörper aufweist, der über das Kabel geschoben werden kann. An den beiden Enden des hohlzylindrischen Grundkörpers der Kontakthülse sind umfangsseitig verteilt mehrere Federzungen vorhanden. Diese Federzungen werden einerseits mit der Abschirmung des Kabels, insbesondere dessen Abschirmgeflecht, elektrisch kontaktier, wenn ein Kabelstutzen über diese Federzungen geschoben wird. Andererseits werden die anderen Federzungen mit einem Anschlag kontaktiert, wenn ebenfalls der Kabelstutzen über das Kabel geschoben und in seiner Endlage positioniert worden ist.

Diese Ausgestaltung des Schirmkontaktelementes kommt zur Anwendung bei Hochvolt-Kabeln für Elektro- oder Hybridfahrzeuge, weil bei derartigen Hochvolt-Kabeln eine Abschirmung erforderlich ist, um aufgrund der verwendeten Spannungen im Bereich von etwa 300 Volt bis 800 Volt die übrige Bordnetzelektronik, die im Niederspannungsbereich (zum Beispiel 12 oder 24 Volt) arbeitet, von Störeinflüssen freizuhalten. Dazu ist es erforderlich, die Abschirmung des Kabels zu dem elektrischen Gerät, insbesondere dessen metallischen Gehäuse, welches ebenfalls eine Abschirmung bewirkt, durchzuschleifen, wobei mit dem Kabel Sensoren, Aktoren oder dergleichen an das elektrische Gerät angeschlossen werden. Hierzu ist es erforderlich, bei der Montage des Kabels an dem elektrischen Gerät, zum Beispiel mittels eines Steckverbinders durch einen Steckvorgang, mittels des bekannten Schirmkontaktelementes diese Abschirmung durchzuschleifen.

Allerdings besteht bei dem bekannten Schirmkontaktelement die Gefahr, dass aufgrund der nach außen abstehenden einzelnen Federzungen diese Federzungen bei der Montage, aber auch bei der Lagerhaltung, verbogen werden, sodass entweder gar keine Montage mehr erfolgen kann oder die Abschirmung nicht ausreichend ist, wenn das Schirmkontaktelement mit in unzulässiger Weise umgebogenen Federzungen montiert worden ist.

Der Erfindung liegt daher die Aufgabe zugrunde, ein gattungsgemäßes Schirmkontaktelement dahingehend zu verbessern, dass damit die funktionsgerechte Montage verbessert wird unter gleichzeitiger Beibehaltung der erforderlichen Abschirmwirkung.

Diese Aufgabe ist durch die Merkmale des Patentanspruches 1 gelöst.

Erfindungsgemäß ist vorgesehen, dass die Federelemente als an einem Ende des hohlzylindrischen Grundkörpers angeordnet außen liegende Federelemente zur Kontaktierung mit dem elektrischen Gerät und als an dem anderen Ende des hohlzylindrischen Grundkörpers angeordnete innenliegende Federelemente zur Kontaktierung zu der Abschirmung des Kabels ausgebildet sind. Der Vorteil dieser Ausgestaltung des Schirmkontaktelementes ist darin zu sehen, dass die innenliegenden Federelemente nicht mehr nach außen, also außerhalb der äußeren Oberfläche des hohlzylindrischen Grundkörpers oder davon abstehend, abstehen, sodass dadurch wirksam die Verbiegung vermieden wird. Die Anordnung der außenliegenden Federelemente innerhalb des hohlzylindrischen Grundkörpers, aber über dessen äußere Oberfläche hinausragenden Federelemente hat den Vorteil, dass auch dadurch die Federelemente nicht wie im Stand der Technik verbogen werden können, weil sie frei abstehen, sondern weil sie teilweise von dem hohlzylindrischen Grundkörper geschützt werden und nur solche Bereiche der Federelemente über die äußere Oberfläche des hohlzylindrischen Grundkörpers hinausragen, mit denen die elektrische Kontaktierung zu dem Gehäuse des elektrischen Gerätes erfolgen soll.

Erfindungsgemäß weist der hohlzylindrische Grundkörper an seinem einen Ende umfangsseitig mehrere Ausnehmungen auf, in die die außenliegenden Federelemente eingesetzt und festgelegt sind. Durch diese Ausnehmungen wird es ermöglicht, dass ein Teilbereich der außenliegenden Federelemente über die äußere Oberfläche des hohlzylindrischen Grundkörpers hinausragen, während die übrigen, insbesondere die benachbarten Bereiche des über die Oberfläche hinausragenden Bereiches des Federelementes an dem Grundkörper angeordnet sind. In diesem Fall können die Federelemente entweder von dem hohlzylindrischen Grundkörper selbst gebildet werden oder sie stellen separate Bauteile dar, die getrennt von dem Grundkörper hergestellt und in die Ausnehmungen in dem Grundkörper eingesetzt und festgelegt werden.

Erfindungsgemäß sind die außenliegenden Federelemente und/oder die innenliegenden Federelemente als Ringelemente ausgebildet, wobei das Ringelement zumindest einen Ring aufweist, von dem die einzelnen Federelemente abstehen. Ein solches Ringelement wird separat von dem hohlzylindrischen Grundkörper hergestellt und kann nach seiner Herstellung und nach der Herstellung des Grundkörpers in diesen eingesetzt und festgelegt werden. Insbesondere erfolgt in vorteilhafter Weise der Einsatz der außenliegenden Federelemente, die an dem Ring angeordnet sind, in Ausnehmungen in dem hohlzylindrischen Grundkörper, sodass die außenliegenden Federelemente über ihren einen Endbereich an dem Ring festgelegt sind, wohingegen die anderen Endbereiche der Federelemente, die von dem Ring abstehen, in die Ausnehmung eingesetzt sind. Diese Ausnehmung erfolgt derart, dass ein Teilbereich der Federelemente über die äußere Oberfläche des hohlzylindrischen Grundkörpers herausragt, um einerseits die elektrische Kontaktierung an dem elektrischen Gerät zu realisieren und andererseits eine Federwirkung dauerhaft zu erzielen, wenn dieser Bereich des Federelementes an dem elektrischen Gerät anliegt. Gleiches gilt für die innenliegenden Federelemente, die ebenfalls in Ausnehmungen eingesetzt und festgelegt werden können, wobei dann der von dem Ring abstehende Teil des Federelementes nach innen weist und über die innere Oberfläche des hohlzylindrischen Grundkörpers hinausragt. Denkbar ist aber auch, dass das Ringelement mit den innenliegenden Federelementen in den inneren Bereich des hohlzylindrischen Grundkörpers eingesetzt und festgelegt wird, wobei dann die freien Enden der innenliegenden Federelemente nach innen abstehen, um sich an die Abschirmung des Kabels anzulegen, wenn die Schirmkontakthülse bestimmungsgemäß auf dem Kabel angeordnet und festgelegt wurde.

Alternativ zu der Ausgestaltung der außenliegenden bzw. innenliegenden Federelemente an einem einzigen Ring des Ringelementes ist es denkbar, das Ringelement mit zwei Ringen, die beabstandet zueinander angeordnet sind, anzuordnen, sodass die beiden zueinander beabstandeten Ringe durch die Federelemente miteinander verbunden werden. Auch ein solches Ringelement mit zwei zueinander beabstandeten Ringen, die über die Federelemente, die umfangsseitig verteilt sind, verbunden sind, kann separat von dem hohlzylindrischen Grundkörper hergestellt und nach seiner Herstellung dort eingesetzt und festgelegt werden.

Sowohl für die Herstellung des hohlzylindrischen Grundkörpers als auch für das Ringelement mit einem Ring oder mit zwei Ringen gilt, dass diese in besonders vorteilhafter Weise aus einem flachen metallischen Werkstoff einfach, schnell und unkompliziert in einem Stanzroll-, Stanzbiege- oder einem anderen geeigneten Verfahren hergestellt werden kann.

In Weiterbildung der Erfindung ist das Ringelement mit seinem Ring (entweder mit seinem einzigen Ring oder mit einem von den beiden Ringen) über eine von dem hohlzylindrischen Grundkörper gebildete Umbördelung an dem hohlzylindrischen Grundkörper festgelegt. Die Umbördelung kann beispielsweise in Form einer abstehenden Lasche mit Herstellung des hohlzylindrischen Grundkörpers hergestellt werden. Ist der Grundkörper soweit vorbereitet, kann das separat hergestellte Ringelement, genauso aber auch wie anders gestaltet Federelemente, an der gewünschten Position an dem Grundkörper angeordnet und durch Umbördeln der abstehenden Lasche an dem Grundkörper zur Bildung der Umbördelung festgelegt werden. Damit steht eine einfache Art und Weise der Festlegung der Federelemente bzw. des Ringes bzw. des Ringelementes zur Verfügung, die vorzugsweise automatisiert erfolgen kann.

In Weiterbildung der Erfindung weist der hohlzylindrische Grundkörper auf seiner äußeren Oberfläche zumindest eine abstehende Lasche auf. Mittels dieser Lasche, die vorzugsweise aus dem Grundkörper ausgestanzt und umgebogen wird, steht ein Anschlag zur Verfügung, mit dem der Grundkörper in seine bestimmungsgemäße Position entweder an dem Kabel und/oder an dem elektrischen Gerät gebracht werden kann. Wird beispielsweise der Grundkörper auf einen entsprechend gestalteten Vorsprung des Gehäuses des elektrischen Gerätes aufgeschoben, wird mittels der zumindest einen Lasche, vorzugsweise aber mehreren vorstehenden Laschen, seine Lage an dem elektrischen Gerät festgelegt, weil durch die Lasche eine weitere axiale Bewegung des Grundkörpers nicht mehr möglich ist. Gleiches gilt für seine Anordnung auf dem Kabel.

In Weiterbildung der Erfindung weist der hohlzylindrische Grundkörper auf seiner äußeren Oberfläche zumindest einen Rasthaken auf. Mittels dieses Rasthakens wird der Grundkörper an seiner bestimmungsgemäßen Position festgelegt. Das bedeutet, dass der Grundkörper dann, wenn er in seine bestimmungsgemäße Position gebracht wird (wobei die Verbringung in diese Position zum Beispiel durch die vorstehend beschriebene abstehende Lasche begrenzt wird) der Rasthaken wirksam wird und in eine korrespondierende Ausnehmung, einen korrespondierenden Rasthaken oder dergleichen eingreift, wenn der Grundkörper seine bestimmungsgemäße Position erreicht hat. Vor allen Dingen durch das Zusammenspiel von abstehender Lasche (Begrenzung) und Rasthaken (Festlegung) wird die bestimmungsgemäße Position des Grundkörpers fixiert.

In Weiterbildung der Erfindung weist der hohlzylindrische Grundkörper auf seiner äußeren Oberfläche zumindest einen axial ausgerichteten Steg auf. Mittels dieses zumindest einen axial ausgerichteten Steges ist eine Führung des Grundkörpers gegeben, wenn dieser in seine bestimmungsgemäße Position gebracht wird. Zur Verbesserung dieser Führung ist nicht nur ein axial ausgerichteter Steg auf der Oberfläche des hohlzylindrischen Grundkörpers vorhanden, sondern mehrere Stege. Diese mehreren Stege sind in besonders vorteilhafter Weise gleichmäßig über den Umfang der äußeren Oberfläche des Grundkörpers verteilt, sodass dadurch eine symmetrische Anordnung der Stege auf der äußeren Oberfläche des Grundkörpers gegeben ist.

In Weiterbildung der Erfindung weist der hohlzylindrische Grundkörper in seinem axialen Verlauf zumindest einen Durchmessersprung auf. Mittels dieses Durchmessersprunges wird ebenfalls die Lage des Grundkörpers bei der Montage an dem elektrischen Gerät bzw. die Lage des Kabels in dem Grundkörper fixiert.

In Weiterbildung der Erfindung weist der hohlzylindrische Grundkörper auf seiner inneren Oberfläche zumindest einen axial ausgerichteten Steg auf. Mittels dieses zumindest einen axial ausgerichteten innenliegenden Steges kann ebenfalls eine Führung bei der Montage des Grundkörpers des Schirmkontaktelementes realisiert werden. Es ist aber auch denkbar, diesen Steg, der separat von dem Grundkörper hergestellt worden ist, dazu zu verwenden, die innen- und außenliegenden Federelemente bzw. das Ringelement mit seinem einen Ring (wenn nur ein Ring vorhanden ist) bzw. mit seinem einen von zwei Ringen an dem hohlzylindrischen Grundkörper des Schirmkontaktelementes festzulegen. Durch den zumindest einen innenliegenden axial ausgerichteten Steg können somit die Federelemente an den Enden des hohlzylindrischen Grundkörpers beispielsweise wiederum mittels einer Umbördelung zusätzlich zu der schon vorhandenen Umbördelung an dem Grundkörper oder unabhängig davon festgelegt werden. Dieser zumindest eine axial ausgerichtete Steg hat also den Vorteil, dass dadurch die innenliegenden und außenliegenden Federelemente lagerichtig und vor allen Dingen im korrekten Abstand zueinander im jeweiligen Endbereich des hohlzylindrischen Grundkörpers des Schirmkontaktelementes angeordnet und festgelegt werden.

Ein Ausführungsbeispiel eines Schirmkontaktelementes für das Zusammenwirken mit einem Kabel mit einer Abschirmung und einem elektrischen Gerät ist im Folgenden beschrieben und anhand der Figuren erläutert.

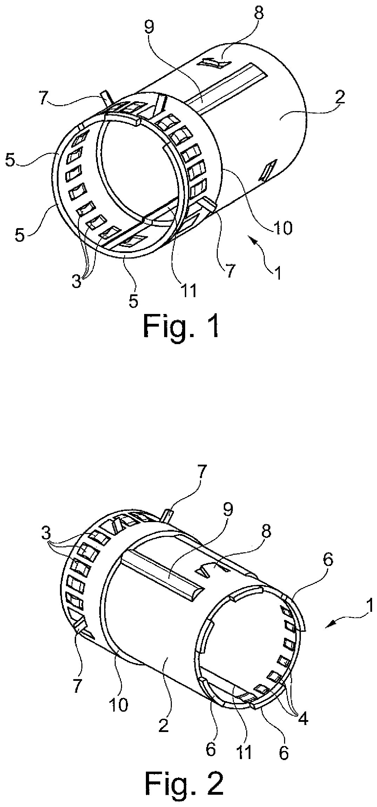

Die Figuren 1 und 2 zeigen, soweit im Einzelnen dargestellt, in verschiedenen Ansichten ein Schirmkontaktelement 1, welches einen hohlzylindrischen Grundkörper 2 aufweist. Dieser hohlzylindrische Grundkörper 2 wird beispielsweise aus einem metallischen Flachmaterial in einem Stanzrollverfahren hergestellt. Separat davon werden außenliegende Federelemente 3 und innenliegende Federelemente 4 hergestellt. Bei diesem Ausführungsbeispiel sind die Federelemente 3, 4 zwischen zwei nicht näher bezeichneten Ringen angeordnet, wobei die außenliegenden Federelemente 3 zwischen den beiden Ringen eine Art Höcker bilden, der über die äußere Oberfläche des Grundkörpers 2 hinausragt. Bei den innenliegenden Federelementen 4 sind diese analog dazu gebildet, sodass sie zwischen den beiden Ringen eine Art nach innen weisenden Höcker aufweisen. Ein solches Ringelement mit den außenliegenden Federelementen 3 bzw. den innenliegenden Federelementen 4 kann ebenfalls in einem geeigneten Stanzbiegeverfahren separat von dem Grundkörper 2 hergestellt und danach an diesem angeordnet werden. Der Querschnitt des zumindest einen Ringes, vorzugsweise beider Ringe, der Ringelemente kann rund, oval oder dergleichen sein. Von besonderem Vorteil ist ein in etwa flacher rechteckförmiger Querschnitt, um somit den zur Verfügung stehenden Bauraum innerhalb des hohlzylindrischen Grundkörpers 2 optimal auszunutzen. Nachdem die Federelemente 3, 4 bestimmungsgemäß an dem hohlzylindrischen Grundkörper 2 angeordnet worden sind, werden die außenliegenden Federelemente 3 mittels einer Umbördelung 5 und die innenliegenden Federelemente 4 mittels einer Umbördelung 6 an dem Grundkörper 2 festgelegt. Die Umbördelungen 5, 6 können jeweils einmal, vorzugsweise aber mehrfach über den Umfang verteilt stirnseitig an dem Grundkörper 2 vorhanden sein, wie dies in den Figuren 1 und 2 dargestellt ist. Die Umbördelungen 5, 6 weisen in den Figuren 1 und 2 die bestimmungsgemäße Verformung auf, um die Federelemente 3, 4 an dem Grundkörper 2 festzulegen. Vor ihrer Umformung sind sie beispielsweise als von den beiden Stirnseiten des Grundkörpers 2 abstehende Laschen ausgebildet.

Die außenliegenden Federelemente 3 sind, wie in Figur 1 erkennbar, nicht nur über die äußere Oberfläche des Grundkörpers 2 hinausragend ausgebildet, sondern deren Basis, insbesondere deren Ring oder deren Ringe, an deren Ende sie befestigt sind, liegen innerhalb des hohlzylindrischen Grundkörpers 2. Damit entsprechende Kontaktbereiche der Federelemente 3 über die äußere Oberfläche des Grundkörpers 2 hinausragen können, ist der entsprechende Endbereich des Grundkörpers mit über den Umfang verteilten Ausnehmungen versehen, durch die die außenliegenden Federelemente 3 angeordnet sind, damit deren Kontaktbereiche über die äußere Oberfläche des Grundkörpers 2 hinausragen können. Dies ist bei den innenliegenden Federelementen 4 nicht erforderlich, da deren Kontaktbereich nach innen in Richtung der Abschirmung des Kabels weisen muss. Daher sind die Federelemente 4 innenliegend an der inneren Oberfläche des hohlzylindrischen Grundkörpers 2 angeordnet und festgelegt. Dies erfolgt wie schon ausgeführt durch eine Befestigung eines jeden einzelnen innenliegenden Federelementes 4 an der inneren Oberfläche des Grundkörpers 2 oder über das Ringelemente mit nur einem Steg oder mit zwei Stegen.

Weiter ist in den Figuren 1 und 2 erkennbar, dass der Grundkörper 2 zumindest eine nach außen abstehende Lasche 7, vorzugsweise mehrere abstehende Laschen 7 aufweist. Diese Laschen 7 können beispielsweise aus dem Grundkörper 2 ausgestanzt werden und mit ihrem einen Ende an dem Grundkörper 2 verbleiben und um diesen Bereich abgewinkelt werden, damit sie nach außen abstehen.

Gleiches gilt für Rasthaken 8, die analog zu den Laschen 7 hergestellt werden können. Mittels beispielsweise einer Verprägung ist es möglich, auf der äußeren Oberfläche des Grundkörpers 2 zumindest einen axial verlaufenden Steg 9 zur Führung des Grundkörpers 2 des Schirmkontaktelementes 1 bei seiner Montage zu realisieren. Diese Verprägung, die den Steg 9 bildet, kann in das flache Ausgangsmaterial schon eingebracht werden, bevor es zu dem hohlzylindrischen Grundkörper 2 gerollt wird.

Außerdem ist in den Figuren 1 und 2 gezeigt, dass der Grundkörper 2 einen Durchmessersprung 10 aufweist. Dieser Durchmessersprung 10 begrenzt die Lage des Schirmkontaktelementes 1 bei seinem Einbau an dem elektrischen Gerät bzw. wenn es auf das Kabel aufgeschoben wird.

Weiterhin ist noch zumindest ein innenliegender Steg 11, vorzugsweise mehrere innenliegende Stege 11, vorhanden. Diese innenliegenden Stege 11 können entweder ebenfalls als Verprägung ausgebildet sein und eine Führung des Schirmkontaktelementes 1 bei seiner Montage bewirken. Alternativ dazu ist es denkbar, dass die innenliegenden Stege 11 als separate Bauteile ausgebildet sind und in ihren Endbereichen jeweils eine Lasche aufweisen, mit denen sie mittels einer Umbördelung entweder an einem Ring des Ringelementes oder an einer Stirnseite des Grundkörpers 2, vorzugsweise an beiden Stirnseiten des Grundkörpers 2, festgelegt werden. Dabei erfolgt in besonders vorteilhafter Weise die Festlegung des Steges 11 mit der Umbördelung nicht nur an der Stirnseite des Grundkörpers 2, sondern dadurch wird auch ein Ring des Ringelementes für die Federelemente 3, 4 mit festgelegt. Durch diese zweifache Umbördelung (nämlich die Umbördelung mittels des Steges 11 und der Umbördelungen 5 bzw. 6) werden die Ringelemente mit den Federelementen 3, 4 dauerhaft und wirksam an dem Grundkörper 2 festgelegt und auf dem erforderlichen Abstand zueinander gehalten. In diesem Fall können die Stege 11, müssen aber nicht, eine axiale Führung bei der Montage des Schirmkontaktelementes 1 bewirken.

Nicht dargestellt, aber vorhanden, ist ein mit dem einen Endbereich, in dem die außenliegenden Federelemente 3 angeordnet sind, korrespondierender Bereich des elektrischen Gerätes, der beispielsweise als vorstehender Zapfen zur Durchführung des Kabels in das Innere des elektrischen Gerätes ausgebildet ist. Auf diesen Zapfen wird das Schirmkontaktelement 1 unter Anlage der Federelemente 3 aufgeschoben. Nach diesem Montagevorgang wird in bevorzugter Weise noch ein Element über das Schirmkontaktelement 1 übergeschoben, um dieses dauerhaft sowohl an dem elektrischen Gerät als auch auf dem Kabel festzulegen. Außerdem bewirkt ein solches zusätzliches Element gegebenenfalls eine Zugentlastung sowie einen Schutz vor äußeren Einflüssen (beispielsweise Knickschutz, Längswasserdichtheit und dergleichen).

### Bezugszeichenliste

- 1.: Schirmkontaktelement
- 2.: Hohlzylindrischer Grundkörper
- 3.: Außenliegende Federelemente
- 4.: Innenliegende Federelemente
- 5.: Umbördelung
- 6.: Umbördelung
- 7.: Lasche
- 8.: Rasthaken
- 9.: Steg
- 10.: Durchmessersprung
- 11.: Innenliegender Steg

## Patentansprüche

1. Schirmkontaktelement (1) mit axial zueinander beabstandeten an einem hohlzylindrischen Grundkörper (2) angeordneten Federelementen, wobei mittels der Federelemente einerseits die Kontaktierung zu einer Abschirmung eines Kabels und andererseits die Kontaktierung zu einem elektrischen Gerät erfolgt, wobei die Federelemente als an einem Ende des hohlzylindrischen Grundkörpers (2) angeordnete außenliegende Federelemente (3) zur Kontaktierung mit dem elektrischen Gerät und als an dem anderen Ende des hohlzylindrischen Grundkörpers (2) angeordnete innenliegende Federelemente (4) zur Kontaktierung zu der Abschirmung des Kabels ausgebildet sind, und wobei der hohlzylindrische Grundkörper (2) an seinem einen Ende umfangsseitig mehrere Ausnehmungen aufweist, in die die außenliegende Federelemente (3) eingesetzt und festgelegt sind, **dadurch gekennzeichnet, dass** die außenliegenden Federelemente (3) und/oder die innenliegenden Federelemente (4) als Ringelemente ausgebildet sind, wobei das Ringelement zumindest einen Ring aufweist, von dem die einzelnen Federelemente (3, 4) abstehen.

2. Schirmkontaktelement (1) nach Anspruch 1, **dadurch gekennzeichnet, dass** das Ringelement zwei zueinander beabstandete Ringe aufweist, wobei die außenliegenden Federelemente (3) und/oder die innenliegenden Federelemente (4) zwischen den beiden Ringen angeordnet sind.

3. Schirmkontaktelement (1) nach Anspruch 2, **dadurch gekennzeichnet, dass** das Ringelement mit seinem Ring über eine von dem hohlzylindrischen Grundkörper (2) gebildeten Umbördelung (5, 6) an dem hohlzylindrischen Grundkörper (2) festgelegt ist.

4. Schirmkontaktelement (1) nach einem der vorhergehenden Ansprüche, **dadurch gekennzeichnet, dass** der hohlzylindrische Grundkörper (2) auf seiner äußeren Oberfläche zumindest eine abstehende Lasche (7) aufweist.

5. Schirmkontaktelement (1) nach einem der vorhergehenden Ansprüche, **dadurch gekennzeichnet, dass** der hohlzylindrische Grundkörper (2) auf seiner äußeren Oberfläche zumindest einen Rasthaken (8) aufweist.

6. 8. Schirmkontaktelement (1) nach einem der vorhergehenden Ansprüche, **dadurch gekennzeichnet, dass** der hohlzylindrische Grundkörper (2) auf seiner äußeren Oberfläche zumindest einen axial ausgerichteten Steg (9) aufweist.

7. Schirmkontaktelement (1) nach einem der vorhergehenden Ansprüche, **dadurch gekennzeichnet, dass** der hohlzylindrische Grundkörper (2) in seinem axialen Verlauf zumindest einen Durchmessersprung (10) aufweist.

8. Schirmkontaktelement (1) nach Anspruch 1, **dadurch gekennzeichnet, dass** der hohlzylindrische Grundkörper (2) auf seiner inneren Oberfläche zumindest einen axial ausgerichteten Steg (11) aufweist.

## Claims

1. Shield contact element (1) comprising spring elements which are axially spaced apart from one another and are arranged on a hollow-cylindrical main body (2), wherein firstly contact is made with a shielding of a cable and secondly contact is made with an electrical device by means of the spring elements, wherein the spring elements are designed as external spring elements (3), which are arranged at one end of the hollow-cylindrical main body (2), for making contact with the electrical device and as internal spring elements (4), which are arranged at the other end of the hollow-cylindrical main body (2), for making contact with the shielding of the cable, and wherein the hollow-cylindrical main body (2), over the circumference of one of its ends, has a plurality of recesses into which the external spring elements (3) are inserted and secured, **characterized in that** the external spring elements (3) and/or the internal spring elements (4) are designed as ring elements, wherein the ring element has at least one ring from which the individual spring elements (3, 4) project.

2. Shield contact element (1) according to Claim 1, **characterized in that** the ring element has two rings which are spaced apart from one another, wherein the external spring elements (3) and/or the internal spring elements (4) are arranged between the two rings.

3. Shield contact element (1) according to Claim 2, **characterized in that** the ring element, by way of its ring, is secured to the hollow-cylindrical main body (2) via a beading (5, 6) which is formed by the hollow-cylindrical main body (2).

4. Shield contact element (1) according to one of the preceding claims, **characterized in that** the hollow-cylindrical main body (2), on its outer surface, has at least one projecting lug (7).

5. Shield contact element (1) according to one of the preceding claims, **characterized in that** the hollow-cylindrical main body (2), on its outer surface, has at least one latching hook (8).

6. Shield contact element (1) according to one of the preceding claims, **characterized in that** the hollow-cylindrical main body (2), on its outer surface, has at least one axially oriented web (9).

7. Shield contact element (1) according to one of the preceding claims, **characterized in that** the hollow-cylindrical main body (2), in its axial course, has at least one diameter step (10).

8. Shield contact element (1) according to Claim 1, **characterized in that** the hollow-cylindrical main body (2), on its inner surface, has at least one axially oriented web (11).

## Revendications

1. Élément de contact de blindage (1) muni d'éléments de suspension agencés espacés axialement les uns des autres sur un corps de base cylindrique creux (2), les éléments de suspension permettant d'un côté le contact avec un blindage d'un câble et d'un autre côté le contact avec un appareil électrique, les éléments de suspension étant configurés sous la forme d'éléments de suspension extérieurs (3) agencés à une extrémité du corps de base cylindrique creux (2) pour le contact avec l'appareil électrique et sous la forme d'éléments de suspension intérieurs (4) agencés à l'autre extrémité du corps de base cylindrique creux (2) pour le contact avec le blindage du câble, et le corps de base cylindrique creux (2) comprenant à une de ses extrémités plusieurs cavités du côté périphérique, dans lesquelles les éléments de suspension extérieurs (3) sont insérés et fixés, **caractérisé en ce que** les éléments de suspension extérieurs (3) et/ou les éléments de suspension intérieurs (4) sont configurés sous la forme d'éléments annulaires, l'élément annulaire comprenant au moins un anneau, à partir duquel les éléments de suspension individuels (3, 4) font saillie.

2. Élément de contact de blindage (1) selon la revendication 1, **caractérisé en ce que** l'élément annulaire comprend deux anneaux espacés l'un de l'autre, les éléments de suspension extérieurs (3) et/ou les éléments de suspension intérieurs (4) étant agencés entre les deux anneaux.

3. Élément de contact de blindage (1) selon la revendication 2, **caractérisé en ce que** l'élément annulaire est fixé sur le corps de base cylindrique creux (2) avec son anneau par l'intermédiaire d'un bord rabattu (5, 6) formé par le corps de base cylindrique creux (2).

4. Élément de contact de blindage (1) selon l'une quelconque des revendications précédentes, **caractérisé en ce que** le corps de base cylindrique creux (2) comprend au moins une patte en saillie (7) sur sa surface extérieure.

5. Élément de contact de blindage (1) selon l'une quelconque des revendications précédentes, **caractérisé en ce que** le corps de base cylindrique creux (2) comprend au moins un crochet d'encliquetage (8) sur sa surface extérieure.

6. Élément de contact de blindage (1) selon l'une quelconque des revendications précédentes, **caractérisé en ce que** le corps de base cylindrique creux (2) comprend au moins une entretoise dirigée axialement (9) sur sa surface extérieure.

7. Élément de contact de blindage (1) selon l'une quelconque des revendications précédentes, **caractérisé en ce que** le corps de base cylindrique creux (2) comprend au moins un saut de diamètre (10) dans son extension axiale.

8. Élément de contact de blindage (1) selon la revendication 1, **caractérisé en ce que** le corps de base cylindrique creux (2) comprend au moins une entretoise dirigée axialement (11) sur sa surface intérieure.
